# EUROPEAN PATENT APPLICATION

(11) **EP 4 507 465 A1**
(43) Date of publication of application: **12.02.2025**
(21) Application number: 23306346.0
(22) Date of filing: 07.08.2023
(51) Int. Cl.: H05K 7/20

(54) **DATACENTER LIQUID COOLING ARRANGEMENTS WITH POWER ESTIMATION AND RELATED FAN AND PUMP CONTROL**

(71) Applicant: OVH, 59100 Roubaix (FR)
(72) Inventor: CHEHADE, Ali, 59283 Moncheaux (FR); HNAYNO, Mohamad, 59100 Roubaix (FR)
(74) Representative: BCF Global

(57) **Abstract**

A liquid cooling method and system for estimating power consumption of cooling rack-mounted processing assemblies and controlling corresponding fan and pump speeds, is presented. The presented method and system provide for the estimation of the power consumption of the rack-mounted data processing assemblies by calculating a thermal load based on measured cooling liquid temperatures, heated liquid temperatures, ambient dry cooler temperatures, and cooling liquid volume and controlling the fan speed based on the estimated power consumption. The presented method and system also provide for controlling the pump speed based on measured flow rates and corresponding empirically derived pump head pressure values H.

## Description

### FIELD

The present technology generally relates to the field of datacenter liquid cooling arrangements and, in particular, to the power estimation of datacenter rack-mounted processing assemblies and related control of cooling pumps and fans.

### BACKGROUND

Datacenters as well as many computer processing facilities house multitudes rack-mounted electronic processing equipment. In operation, such electronic processing equipment generates a substantial amount of heat that must be dissipated in order avoid electronic component failures and ensure continued efficient processing operations.

To this end, various liquid cooling measures have been implemented to facilitate the dissipation of heat generated by the electronic processing equipment. One such measure employs liquid block cooling techniques for directly cooling one or more heat-generating processing components. This technique utilizes liquid cooling blocks having internal channels that receive cooling liquid from a cooling liquid source, e.g., heat exchangers, dry coolers, municipal water supply *etc*., via a liquid cooling loop arrangement to circulate the cooling liquid throughout the equipment. As such, the liquid cooling blocks are positioned to be in direct thermal contact with the heat-generating components, so that the received cooling liquid absorbs the generated heat and the heated liquid is circulated, via the cooling loop arrangement, back to cooling liquid source for re-cooling.

Another liquid cooling measure employs liquid immersive cooling (IC) techniques, in which the electronic processing equipment is disposed within an immersion case containing cooling dielectric fluid. In this manner, the submerged electronic processing equipment radiates heat that is absorbed by the cooling dielectric fluid in which the heated dielectric fluid is circulated, via a cooling loop arrangement, back to cooling source for re-cooling.

Relatedly, hybrid liquid cooling measures have been introduced that employ a combination of both liquid block cooling techniques and liquid IC techniques as well as various cooling loop arrangements in efforts to maximize the cooling of electronic processing equipment.

It will be appreciated that the extent to which such cooling efforts can be realized are related to the amount of electrical power that is consumed by the electronic processing equipment.

With this said, there remains an interest in estimating the power consumed by the electronic processing equipment to control the operations of various cooling loop components to optimize cooling efficiency. Such cooling loop components include dry cooler fan and pump operations.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

Embodiments of the present technology have been developed based on certain drawbacks associated with conventional dry cooling techniques and implementations.

In one aspect of the inventive concepts of the present technology a liquid cooling method for datacenter rack-mounted processing assemblies with power estimation and related dry cooler fan and pump control, that comprises providing a dry cooling unit to supply a cooling liquid to the rack-mounted processing assemblies and receive a heated liquid from the rack-mounted processing assemblies, the dry cooling unit comprising a fan assembly and a heat exchanger unit; providing a first liquid distribution circuit to convey the cooling liquid from the dry cooling unit to the rack-mounted processing assemblies and a second liquid distribution circuit to convey the heated liquid from the rack-mounted processing assemblies to the dry cooling unit, the first liquid distribution circuit incorporating at least one pump along the first liquid distribution circuit to provide a pressure flow in supplying the cooling liquid from the dry cooling unit to the rack-mounted processing assemblies, in which each of the rack-mounted data processing assemblies comprising at least one heat-generating electronic processing element and at least one liquid cooling block arranged to be in respective thermal contact with the at least one heat-generating electronic processing element and fluidly-coupled to the first liquid distribution circuit and a smart control valve respectively arranged to be fluidly-coupled to the at least one liquid cooling block of the corresponding rack-mounted data processing assembly.

The liquid cooling method further provides a first temperature sensor along the first liquid distribution circuit to measure a temperature of the supplied cooling liquid T_{C}, a volume sensor to measure a flow rate of the supplied cooling liquid V_{C}, a second temperature sensor along the second liquid distribution circuit to measure a temperature of the returned heated cooling liquid T_{H}, and a third temperature sensor to measure an ambient temperature of the dry cooling unit T_{DC}.

The liquid cooling method then provides for estimating a power consumption of the rack-mounted data processing assemblies by calculating a thermal load Q of the first liquid distribution circuit based on the measured T_{C}, T_{H}, and T_{DC} values; controlling a speed of the fan assembly based on the estimated power consumption and/or ambient thermal conditions; determining whether the flow rate has increased based on the measured V_{C} value; and controlling a speed of the at least one pump based on whether the flow rate has increased.

A feature of the liquid cooling method includes controlling the fan assembly speed by evaluating the ambient temperature of the dry cooling unit T_{DC}, a current fan speed value n_{fan}, and estimated fan power consumption value Q_{fan-est}, and operating the fan assembly speed at the current fan speed value n_{fan}, and measuring actual power consumed by the fan assembly Q_{fan-real}.

Another feature of the liquid cooling method includes further controlling the fan assembly speed by determining whether the actual power consumed by the fan assembly Q_{fan-real} is greater than the estimated fan power consumption value Q_{fan-est} and a tolerance factor *K*_{factor} and in response to determining that Q_{fan-real} is greater than Q_{fan-est} and *K*_{factor}, issuing an alert message indicating that the fan assembly is overconsuming power.

An additional feature of the liquid cooling method includes controlling of the at least one pump speed by, in response to determining that the flow rate has increased, incrementally increasing the at least on pump speed nₚᵤₘₚ, determining whether the flow rate has remained the same after increasing the at least one pump speed nₚᵤₘₚ, and in response to determining that the flow rate has not increased, continue to incrementally increase the at least on pump speed Ilpump.

An additional feature of the liquid cooling method includes controlling of the at least one pump speed by, in response to determining that the flow rate has increased, applying a pump head H pressure value to the at least one pump corresponding to the measured flow rate.

Another feature of the liquid cooling method includes controlling of the at least one pump speed by, determining whether the applied H pressure value is less than a prescribed minimum H pressure value Hₘᵢₙ for the measured flow rate; in response to determining that the applied H pressure value is less than Hₘᵢₙ, increasing the at least one pump speed nₚᵤₘₚ; and in response to determining that the applied H pressure value is not less than Hₘᵢₙ, maintaining the previous at least one pump speed nₚᵤₘₚ.

A further feature of the liquid cooling method includes controlling of the at least one pump speed by, in response to determining that the measured flow rate has not increased, incrementally decreasing the pump speed nₚᵤₘₚ, determining whether the flow rate, based on the decreased pump speed nₚᵤₘₚ, has decreased, in response to determining that the flow rate has not decreased, continue to incrementally decrease the at least on pump speed nₚᵤₘₚ, and in response to determining that the flow rate has decreased, incrementally increasing the pump speed nₚᵤₘₚ.

And yet a further feature of the liquid cooling method includes controlling of the at least one pump speed by, applying a pump head H pressure value to the at least one pump corresponding to the measured flow rate, determining whether the applied H pressure value is less than a prescribed minimum H pressure value Hₘᵢₙ for the measured flow rate, in response to determining that the applied H pressure value is less than Hₘᵢₙ, increasing the at least one pump speed nₚᵤₘₚ, and in response to determining that the applied H pressure value is not less than Hₘᵢₙ, maintaining the previous at least one pump speed nₚᵤₘₚ.

In a related aspect of the inventive concepts, the present technology provides a liquid cooling arrangement for estimating power consumption and controlling drycooler fan operations that comprises a dry cooling unit configured to supply a cooling liquid to the rack-mounted processing assemblies and receive a heated liquid from the rack-mounted processing assemblies, the dry cooling unit comprising a fan assembly and a heat exchanger unit; a first liquid distribution circuit configured to convey the cooling liquid from the dry cooling unit to the rack-mounted processing assemblies, the first liquid distribution circuit incorporating at least one pump along the first liquid distribution circuit to provide a pressure flow in supplying the cooling liquid from the dry cooling unit to the rack-mounted processing assemblies; a second liquid distribution circuit configured to convey the heated liquid from the rack-mounted processing assemblies to the dry cooling unit, in which each of the rack-mounted data processing assemblies comprises at least one heat-generating electronic processing element, at least one liquid cooling block arranged to be in respective thermal contact with the at least one heat-generating electronic processing element, the at least one liquid cooling block being fluidly-coupled to the first liquid distribution circuit to receive the cooling liquid and circulate therethrough, and a smart control valve respectively arranged to be fluidly-coupled to the at least one liquid cooling block of the corresponding rack-mounted data processing assembly, the smart control valve configured to be pressure independent and controls the flow rate of the cooling fluid of the corresponding rack-mounted data processing assembly based on detected temperatures and pressure flows.

The liquid cooling arrangement further comprises a first temperature sensor configured to measure a temperature of the supplied cooling liquid T_{C}, a volume sensor to measure a flow rate of the supplied cooling liquid V_{C}, second temperature sensor configured to measure a temperature of the returned heated cooling liquid T_{H}, a third temperature sensor configured to measure an ambient temperature of the dry cooling unit T_{DC}, and a control module, communicatively coupled to the fan assembly and the at least one pump and configured to: receive the measured T_{C}, V_{C}, T_{H}, and T_{DC} values; estimate a power consumption of the rack-mounted data processing assemblies by calculating a thermal load Q of the first liquid distribution circuit based on the measured T_{C}, T_{H}, and T_{DC} values, control a speed of the fan assembly based on the estimated power consumption and/or ambient conditions, determine whether the flow rate has increased based on the measured V_{C} value, and control a speed of the at least one pump based on whether the flow rate has increased.

An additional feature of the liquid cooling arrangement includes controlling the fan assembly speed by operating the fan assembly speed at the current fan speed value n_{fan}, and measuring actual power consumed by the fan assembly Q_{fan-real}; determining whether the actual power consumed by the fan assembly Q_{fan-real} is greater than the estimated fan power consumption value Q_{fan-est} and a tolerance factor *K*_{factor} , and in response to determining that Q_{fan-real} is greater than Q_{fan-est} and *K*_{factor}, issuing an alert message indicating that the fan assembly is overconsuming power.

Another feature of the liquid cooling arrangement includes further controlling the at least one pump speed by, in response to determining that the flow rate has decreased, decreasing the speed of the at least one pump nₚᵤₘₚ; determining whether the flow rate based on the decreased pump speed nₚᵤₘₚ has decreased; in response to determining that the flow rate has not decreased, continue to incrementally decrease the at least on pump speed nₚᵤₘₚ; in response to determining that the flow rate has decreased, incrementally increase the pump speed nₚᵤₘₚ.

A further feature of the liquid cooling arrangement includes controlling of the at least one pump speed by applying a pump head H pressure value to the at least one pump corresponding to the flow rate; determining whether the applied H pressure value is less than a prescribed minimum H pressure value Hₘᵢₙ for the measured flow rate; in response to determining that the applied H pressure value is less than Hₘᵢₙ, increasing the at least one pump speed nₚᵤₘₚ; and in response to determining that the applied H pressure value is not less than Hₘᵢₙ, maintaining the previous at least one pump speed nₚᵤₘₚ.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

Furthermore, in the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

Additionally, in the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 illustrates a high-level functional block diagram of a liquid cooling system for datacenter rack-mounted processing assemblies with power estimation and related control of drycooler fans and pumps, in accordance with the nonlimiting embodiments of the present technology;
FIG. 2 illustrates a flow diagram of a power estimation and fan control process of a liquid cooling system for rack-mounted processing assemblies, in accordance with the non-limiting embodiments of the present technology;
FIG. 3 illustrates a flow diagram of a pump control process of a liquid cooling system for rack-mounted processing assemblies, in accordance with the non-limiting embodiments of the present technology;
FIG. 4 illustrates empirical curves of pump head values relative to flow rates for one and two pumps, in accordance with the non-limiting embodiments of the present technology;
FIG. 5 illustrates a flow diagram of an additional pump control process of a liquid cooling system for rack-mounted processing assemblies, in accordance with the non-limiting embodiments of the present technology; and
FIG. 6 illustrates a high-level functional block diagram of a controller for the liquid cooling system with power estimation with power estimation and related control of dry cooler fans and pumps.

It should be appreciated that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the FIGs. including any functional block labeled as a "processor", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some embodiments of the present technology, the processor may be a general-purpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

Equally noteworthy, while various operations of the inventive concepts may be represented by flowchart elements arranged in certain sequential order, it should be understood that these steps may be combined, sub-divided, re-ordered, or changed to operate concurrently without departing from the teachings of the present technology. In fact, at least some of the processing steps may be executed in parallel or in series. Accordingly, the ordering, sequencing, and grouping of the processing steps is not a limitation of the present technology.

Given this fundamental understanding, the disclosed embodiments are directed to estimating the power consumed by the electronic processing equipment to control the operations of various cooling loop components to optimize cooling efficiency. More particularly, to the control of dry cooler fan and pump operations.

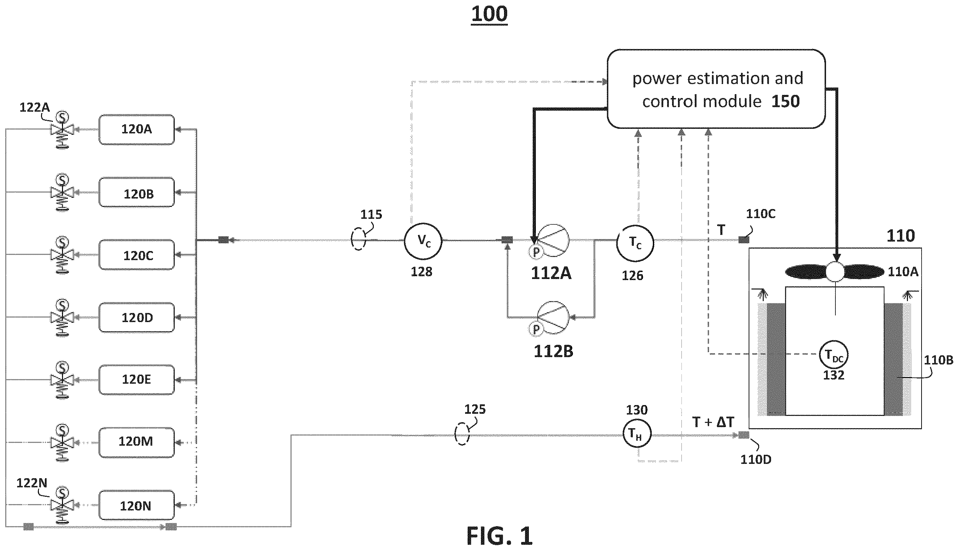

FIG. 1 illustrates the high-level functional block diagram of a liquid cooling system 100 for datacenter rack-mounted processing assemblies processing assemblies with power estimation and related control of dry cooler fans and pumps, in accordance with the nonlimiting embodiments of the present technology, in accordance with the nonlimiting embodiments of the present technology.

As shown, the system **100** includes a dry cooling unit **110**, a plurality of rack-mounted processing assemblies **120A-120N**, a plurality of "smart" valves **122A-122N** in which each smart valve is fluidly-coupled to a respective processing assembly, a forward liquid distribution circuit **115** incorporating a pump **112** for supplying cooling liquid from the dry cooling unit **110**, and a return liquid distribution circuit **125** for returning heated liquid back to the dry cooling unit **110**.

The dry cooling unit **110** incorporates an outlet **110C** configured to supply cooling liquid and an inlet **110D** configured receive heated liquid. The dry cooling unit **110** serves to dissipate thermal energy from a heated liquid circulating therethrough to the ambient environment. For example, in a datacenter or similar facility, the dry cooling unit **110** operates to receive heated liquid from the rack-mounted processing assemblies **120A-120N** (e.g., water circulated through water blocks in contact with heat-generating components) and extracts the thermal energy from the heated liquid by dissipating the energy into the ambient environment via the at least one fan assembly **110A**, thereby re-cooling the heated liquid. The dry cooling unit **110** then operates to supply the re-cooled liquid back to the rack-mounted processing assemblies **120A-120N**.

As shown, the dry cooling unit **110** includes at least one heat exchanger **110B** and at least one fan assembly **110A**. The heat exchanger **110B** may manifest a variety of configurations, such as, air-to-liquid heat exchanger *etc*., and may also include evaporating pads or cooling pads. For purposes of the instant disclosure, the exact configuration of the dry cooling unit **110** and heat exchanger **110B** is not limiting, as various configurations could be employed without departing from the concepts of the instant disclosure.

The cooling/re-cooled liquid is supplied by the dry cooling unit **110** to the rack-mounted processing assemblies **120A-120N** via the outlet **110C** and forward liquid distribution circuit **115**. The forward liquid distribution circuit **115** incorporates at least two pumps **112A, 112B** arranged in a parallel configuration to maintain the flow rate of the cooling/re-cooled liquid supplied to the processing assemblies **120A-120N** at an adequate level. In some implementations, the two pumps **112A, 112B** are configured to operate in a master-slave configuration unless circumstances require the concurrent use of both pumps.

The heated liquid from the rack-mounted processing assemblies **120A-120N** is returned back to the dry cooling unit **110** for re-cooling via the inlet **110D** and return liquid distribution circuit **125**. As shown, the dry cooling unit **110** supplies the cooling/re-cooled liquid to the rack-mounted processing assemblies **120A-120N** at a nominal temperature T and the heated liquid returned to the dry cooling unit **110** is at a nominal temperature T + ΔT, where ΔT represents the temperature differential between the cooling/re-cooled liquid and the heated liquid.

Returning to FIG. 1, the liquid cooling system **100** includes a plurality of rack-mounted processing assemblies **120A-120N** which receive the supplied cooling/re-cooled liquid via the forward liquid distribution circuit **115**, internally channel the liquid to the heat-generating processing components (*e.g*., water circulated through water blocks), and convey the heated liquid from the heat-generating processing components to the return liquid distribution circuit **125**.

The rack-mounted processing assemblies **120A-120N** may or may not be configured with similar heat-generating processing components. As such, each of the rack-mounted processing assemblies **120A-120N** may have different temperature and flow rate requirements for proper operations.

It will be appreciated that, while the rack-mounted processing assemblies **120A-120N** are shown to be arranged in a parallel configuration, it is not meant to be limiting, as the processing assemblies **120A-120N** may also be arranged in a serial or combined parallel and serial configuration without departing from the concepts of the instant disclosure.

As shown, each of the rack-mounted processing assemblies **120A-120N** is fluidly-coupled to a "smart" valve **122A-122N** that dynamically controls the flow rate of the corresponding processing assembly **120A-120N** based on detected liquid temperatures and/or flow rates. For purposes of the instant disclosure, the term "smart" valve refers to a valve that is pressure-independent, temperature-responsive, and incorporates a differential pressure regulator to automatically adjust to system pressure changes. Such smart valves may comprise PICVs, ABQMs, or other functionally similar valves.

The liquid cooling system **100** also incorporates a temperature sensor **126** for measuring the temperature of the supplied cooling liquid T_{C} along the forward liquid distribution circuit **115**, a volume sensor **128** for measuring the flow rate of the supplied cooling liquid Vc along the forward liquid distribution circuit **115**, a temperature sensor for measuring **140** the temperature of the returned heated liquid T_{H} along the return liquid distribution circuit **125**, and a temperature sensor **132** for measuring the ambient temperature of dry cooling unit TDC.

Each of the measured T_{C}, V_{C}, T_{H}, and T_{DC} values are then supplied to estimating and control module **150**. As will be described in detail below, based on these measured values, module **150** functions to determine the estimated power consumed by the rack-mounted processing assemblies **120A-120N** and dynamically controls pressure flow rate of pumps **112A**, **112B** as well as the rotational speed of dry cooling unit fan assembly **110A** to improve cooling system efficiency.

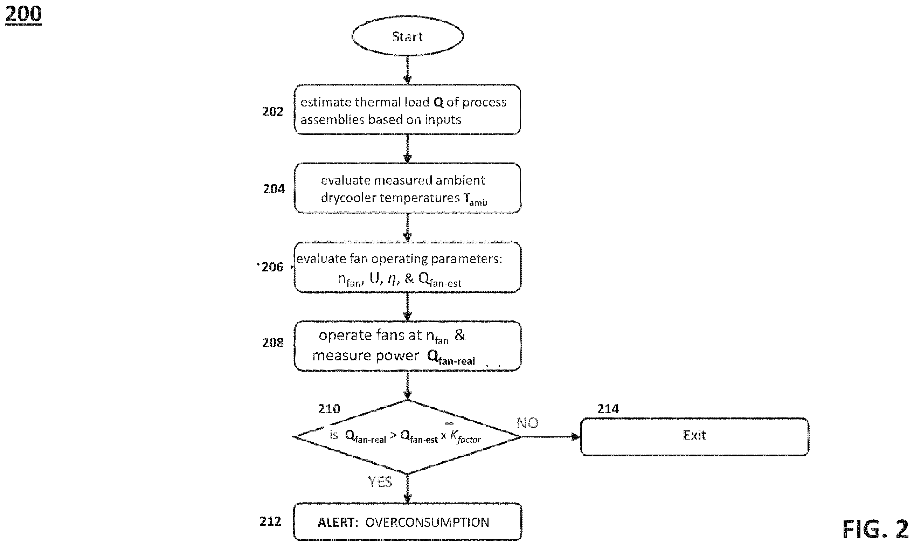

With this said, FIG. 2 illustrates a flow diagram of power estimation and fan control process **200** of a liquid cooling system for rack-mounted processing assemblies, in accordance with the non-limiting embodiments of the present technology. The power estimation and fan control process **200** may be executed by control module **150**. The execution of module **150** may be performed by a controller **600**.

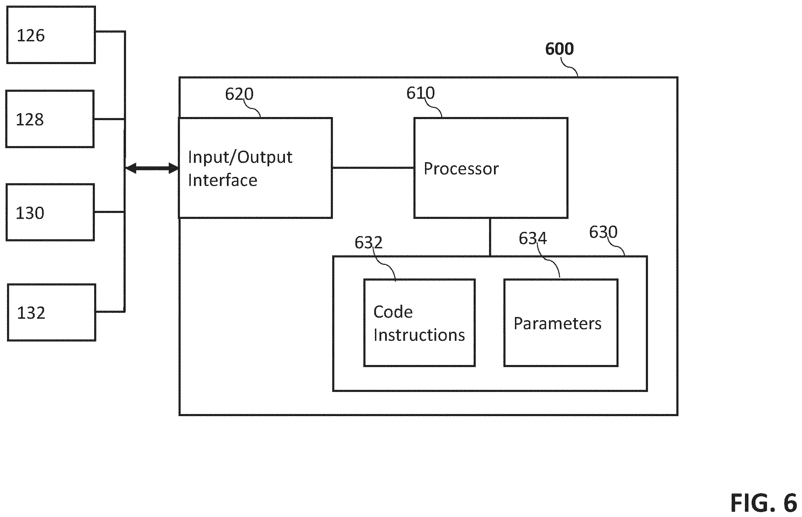

For example, such a controller is depicted by the high-level functional block diagram of FIG. 6. As shown, the controller **600** comprises a processor or a plurality of cooperating processors (represented as a processor **610** for simplicity), a memory device or a plurality of memory devices (represented as a memory device **630** for simplicity), and an input/output interface **620** (or separate input and output interfaces) allowing the controller **600** to communicate with certain components of the liquid cooling arrangement **100**. The processor **610** is operatively connected to the memory device **630** and to the input/output interface **620**. The memory device **630** includes a storage for storing parameters **634**, including for example and without limitation the above-mentioned pre-determined conductivity thresholds. The memory device **630** may comprise a non-transitory computer-readable medium for storing code instructions **632** that are executable by the processor **610** to allow the controller **600** to perform the various tasks allocated to the controller **600**.

The controller **600** is operatively connected, via the input/output interface **620**, to the components of liquid cooling arrangement **100**, such as, the temperature sensor **126** that measures the temperature of cooling liquid T_{C}, the temperature sensor **132** that measures the temperature of cooling liquid T_{DC}, the temperature sensor **130** that measures the temperature of heated liquid T_{H}, and the volume sensor **128** that measures the cooling liquid flow rate V_{C}, The controller **600** executes the code instructions **632** stored in the memory device **630** to implement the various above-described functions of the control module **150**.

However, it will be appreciated that in other embodiments, power estimation and fan control process **200** or portions thereof may be executed by relevant components, such as, for example, temperature sensors, volume sensors, and pumps, etc. For purposes of the instant disclosure, the exact entity or entities executing process **200** is not limiting with regard to the inventive concepts herein presented.

Returning back to FIG. 2, process **200** commences at task block **202**, in which the thermal load Q of the forward liquid distribution circuit **115** is estimated. The thermal load Q of the forward liquid distribution circuit **115** corresponds to the power consumed by the rack-mounted processing assemblies **120A-120N**. As such, process **200** determines ΔT representative of the temperature differential between the supplied cooling liquid temperature, as measured by T_{C}, and the returning heated liquid temperature, as measured by T_{H}. Process 200 then computes the estimated thermal load Q of the forward liquid distribution circuit **115** based on the relationship: thermal load Q = *m* • *cp* • ΔT, where *m* represents the mass flow rate of water and *cp* represents the specific heat calculated as a function of the fluid average temperature.

Process **200** then moves to task block **204** to evaluate the measured ambient temperature of the dry cooling unit **110** T_{DC}, which depends on whether cooling pads are employed. Then, at task block **206**, process **200** evaluates the dry cooling unit fan assembly **110A** operating parameters. Such operating parameters may include, but are not limited to, fan speed n_{fan} (in rotations per minute: rpms), fan piloting voltage U (approximately between 0-10V), fan efficiency parameter *η* (in %), and estimated fan power consumption Q_{fan-est}. It will be appreciated that these operating parameters may be influenced by prevailing conditions, such as, for example, thermal load Q, ambient dry cooling unit temperature T_{DC}, outdoor humidity, and other factors.

Process **200** advances to task block **208**, in which the actual power consumed Q_{fan-real} by the fan assembly **110A** operating at n_{fan} speed (rpms) is measured. Then, at decision block **256**, it is determined whether the actual power consumed by fan assembly, Q_{fan-real}, is greater than the estimated fan power consumption Q_{fan-est} multiplied by a tolerance *K*_{factor}. The tolerance *K*_{factor} value may be based on a variety of desired operational parameters or values, such as, for example, partial power usage efficiency (PPUE), acceptable power margins, *etc.* and in some implementations comprises approximately ± 10%.

If at decision block **210** it is determined that the actual power consumed by fan assembly Q_{fan-real} is not greater than the estimated fan power consumption Q_{fan-est} and *K*_{factor}, then at task block **214,** the process **200** exits indicative that fan assembly **110A** is operating at optimal efficiency. However, if Q_{fan-real} is greater than Q_{fan-est} and *K*_{factor}, process **200** issues an alert message at task block **212** indicating that fan assembly **110A** is not operating efficiently, due to over consumption of power.

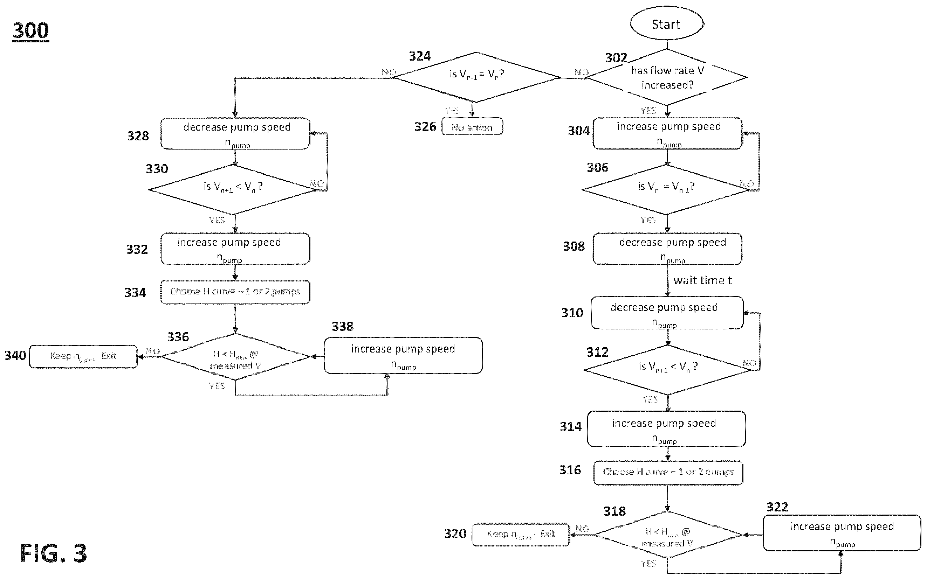

FIG. 3 illustrates a flow diagram of pump control process **300** of a liquid cooling system for rack-mounted processing assemblies, in accordance with the non-limiting embodiments of the present technology. As described above, liquid cooling system **100** implements at least two pumps **112A, 112B** arranged in a parallel configuration to maintain the flow rate of the cooling/re-cooled liquid supplied to the processing assemblies **120A-120N** at an adequate level.

With this said, process **300** commences at decision block **302** to determine whether the measured flow rate V_{C} of the supplied cooling liquid has increased and, if so, process **300** moves to task block **304** to incrementally increase pump speeds nₚᵤₘₚ. Then, at decision block **306**, it is determined whether the flow rate Vₙ is still equal to the previous flow rate Vₙ₋₁. If it is not, then process **300** reverts back to task block **304** to further incrementally increase the pump speeds nₚᵤₘₚ.

However, if at decision block **306**, it is determined that the flow rate Vₙ is still equal to the previous flow rate Vₙ₋₁, then the pump speeds nₚᵤₘₚ are decreased at task block **308** and after a wait time period t, the pump speeds nₚᵤₘₚ are decreased again at task block **310**. The wait time period t is based on operational parameters and in certain implementations may be set from approximately 20 seconds to approximately 45 seconds.

Process **300** then proceeds to decision block **312** to determine whether the new flow rate Vₙ₊₁ is less than the previous flow rate Vₙ and if not, process **300** reverts back to task block **310** to further incrementally decrease the pump speeds nₚᵤₘₚ. However, if the new flow rate Vₙ₊₁ is less than the previous flow rate Vₙ, then process **300** incrementally increases pump speeds nₚᵤₘₚ at task block **314**.

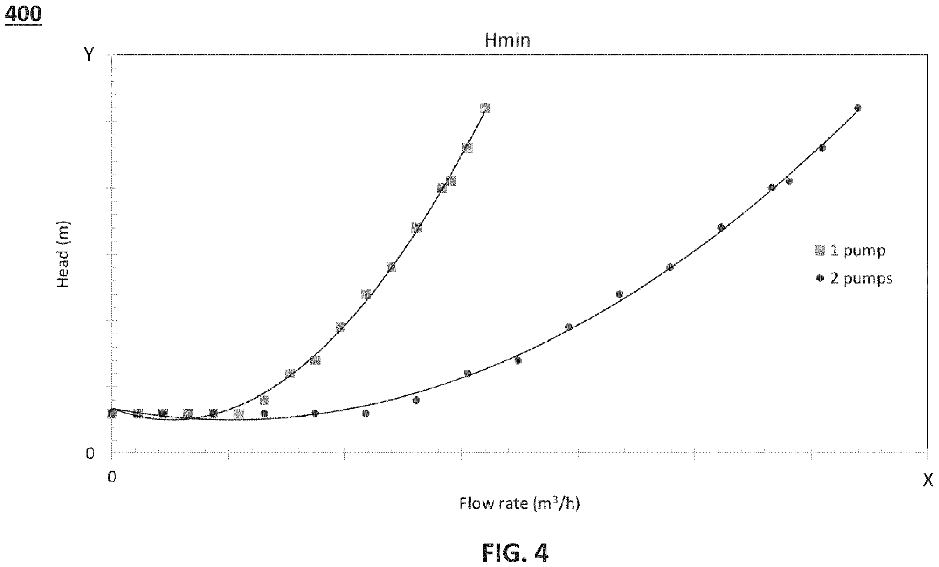

Process **300** then proceeds to task block **316** to select and apply the appropriate H values based on empirically determined pump head H curves **400** as depicted by FIG. 4, in accordance with the non-limiting embodiments of the present technology. Generally, pump head pressure values H are based on a pump's output discharge pressure minus the pump's input suction pressure. As such, the H curves represent empirical data regarding the minimum head pressure values Hₘᵢₙ required to provide the necessary pressure for given flow rates for one and two pumps. Accordingly, process **300** applies the appropriate H pressure values to the pump speed nₚᵤₘₚ based on the use of the one or two pumps **112A, 112B.**

Then, after the appropriate H values are selected and applied, at decision block **318**, process **300** determines whether the applied H pressure values are less than the minimum value Hₘᵢₙ for the measured flow rate V and if so, process **300** incrementally increases the pump speed nₚᵤₘₚ at task block **322**. However, if the applied H pressure values are not less than the minimum value Hₘᵢₙ for the measured flow rate V, the pump speed nₚᵤₘₚ is determined to be efficient and maintained at task block **320**.

Returning back to decision block **302**, if it is determined that the measured flow rate V_{C} of the supplied cooling liquid has not increased, then process **300** moves to decision block **324** to determine whether Vₙ is still equal to the previous flow rate Vₙ₋₁, and if so, then no further controlling action is necessary, as indicated by task block **326**.

However, if at decision block **324**, it is determined that Vₙ is not equal to the previous flow rate Vₙ₋₁, then process **300** moves to incrementally decrease the pump speeds nₚᵤₘₚ at task block **328**. Then at decision block **330**, process **300** determines whether the new flow rate Vₙ₊₁ is less than the previous flow rate Vₙ, and, if not, process **300** reverts back to task block **328** for further incremental decrease of the pump speeds nₚᵤₘₚ. However, if at decision block **330**, it is determined that the new flow rate Vₙ₊₁ is less than the previous flow rate Vₙ, then process **300** moves to task block **332** to incrementally increase the pump speeds nₚᵤₘₚ.

Process **300** advances to task block **334** that selects and applies the appropriate H pressure values to the pump speed nₚᵤₘₚ based on the use of the one or two pumps **112A, 112B**. Then process **300** moves to decision block **336** to determine whether the applied H pressure values are less than the minimum value Hₘᵢₙ for the measured flow rate V and if so, process **300** incrementally increases the pump speed nₚᵤₘₚ at task block **338**. However, if the applied H pressure values are not less than the minimum value Hₘᵢₙ for the measured flow rate V, the pump speed nₚᵤₘₚ is determined to be efficient and maintained at task block **340**.

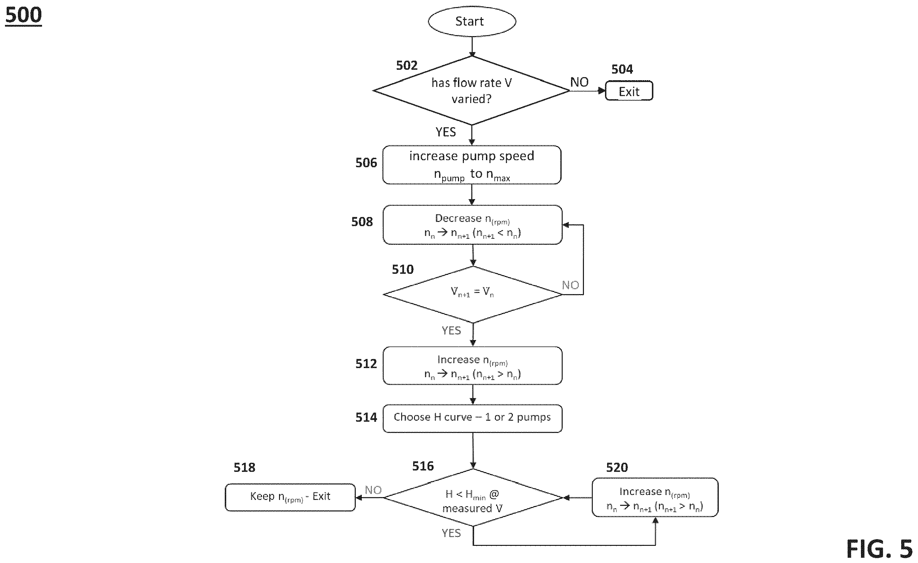

FIG. 5 illustrates a flow diagram of an additional pump control process **500** of a liquid cooling system for rack-mounted processing assemblies, in accordance with the non-limiting embodiments of the present technology. The pump control process **500** is directed to checking and handling sudden flow rate V variations during operations.

In particular, at decision block **502**, process **500** checks to determine whether the flow rate V has varied (*i.e*., increased or decreased) during the course of operations. If not, at task block **504**, process **500** exits. However, if it is determined that flow rate V has varied, at task block **506**, process **500** increases the pump speed nₚᵤₘₚ to a predetermined maximum threshold level nₘₐₓ. Then, at process block **508**, process **500** incrementally decreases the pump speeds nₚᵤₘₚ and at decision block **510** checks whether the new flow rate Vₙ₊₁ is equal to the previous flow rate Vₙ, and if not, process **500** reverts back to task block **508** to continue to incrementally decrease the pump speeds nₚᵤₘₚ.

However, if it is determined at decision block **510**, that the new flow rate Vₙ₊₁ is equal to the previous flow rate Vₙ, then process **500** proceeds to incrementally increase the pump speed nₚᵤₘₚ at task block **512**.

Process **500** then moves to task block **514** to select and apply the appropriate H values and, at decision block **516**, process **500** determines whether the applied H pressure values are less than the minimum value Hₘᵢₙ for the measured flow rate V and if so, process **500** incrementally increases the pump speed nₚᵤₘₚ at task block **520** and returns back to decision block **516** for further checking. However, if the applied H pressure values are not less than the minimum value Hₘᵢₙ for the measured flow rate V, then the pump speed nₚᵤₘₚ is determined to be efficient and maintained at task block **518**.

In this manner, the disclosed configuration and processes function to estimate the power consumed by the electronic processing equipment and accordingly control the operations of the dry cooler fan assembly and pump(s) to optimize the cooling efficiency of the liquid cooling loop arrangements.

While the above-described implementations have been described and shown with reference to particular processing steps performed in a particular sequence or order, it will be understood that these steps may be combined, sub-divided, re-ordered, or changed to operate concurrently without departing from the teachings of the inventive concepts presented herein. In fact, at least some of the processing steps may be alternatively executed in parallel or in series. Accordingly, the ordering, sequencing, and grouping of the processing steps is not a limitation of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A liquid cooling method (200, 300) for rack-mounted processing assemblies (120A-120N), comprising:
providing a dry cooling unit (110) to supply a cooling liquid to the rack-mounted processing assemblies and receive a heated liquid from the rack-mounted processing assemblies, the dry cooling unit comprising a fan assembly (110A) and a heat exchanger unit (110B);
providing a first liquid distribution circuit (115) to convey the cooling liquid from the dry cooling unit to the rack-mounted processing assemblies and a second liquid distribution circuit (125) to convey the heated liquid from the rack-mounted processing assemblies to the dry cooling unit, the first liquid distribution circuit (115) incorporating at least one pump (112A, 112B) along the first liquid distribution circuit (115) to provide a pressure flow in supplying the cooling liquid from the dry cooling unit to the rack-mounted processing assemblies;
each of the rack-mounted data processing assemblies (120A-120N) comprising at least one heat-generating electronic processing element and at least one liquid cooling block arranged to be in respective thermal contact with the at least one heat-generating electronic processing element and fluidly-coupled to the first liquid distribution circuit (115) and a smart control valve (122A-122N) respectively arranged to be fluidly-coupled to the at least one liquid cooling block of the corresponding rack-mounted data processing assembly;
providing a first temperature sensor (126) along the first liquid distribution circuit (115) to measure a temperature of the supplied cooling liquid Tc and a volume sensor (128) to measure a flow rate of the supplied cooling liquid Vc;
providing a second temperature sensor (130) along the second liquid distribution circuit (125) to measure a temperature of the returned heated cooling liquid T_{H};
providing a third temperature sensor (132) to measure an ambient temperature of the dry cooling unit (110) T_{DC};
estimating a power consumption of the rack-mounted data processing assemblies by calculating a thermal load Q of the first liquid distribution circuit based on the measured T_{C}, T_{H}, and T_{DC} values (202);
controlling a speed of the fan assembly based on the estimated power consumption and/or ambient thermal conditions;
determining whether the flow rate has increased based on the measured V_{C} value (302); and
controlling a speed of the at least one pump based on whether the flow rate has increased.

2. The liquid cooling method of claim 1, wherein the controlling of the fan assembly speed further comprises evaluating the ambient temperature of the dry cooling unit T_{DC}, a current fan speed value n_{fan}, and estimated fan power consumption value Q_{fan-est} (204-206).

3. The liquid cooling method of claims 1 or 2, wherein the controlling of the fan assembly speed further comprises operating the fan assembly speed at the current fan speed value n_{fan}, and measuring actual power consumed by the fan assembly Q_{fan-real} (208).

4. The liquid cooling method of claims 2 or 3, wherein the controlling of the fan assembly speed further comprises:
determining whether the actual power consumed by the fan assembly Q_{fan-real} is greater than the estimated fan power consumption value Q_{fan-est} and a tolerance factor *K*_{factor} (210) and
in response to determining that Q_{fan-real} is greater than Q_{fan-est} and *K*_{factor}, issuing an alert message indicating that the fan assembly is overconsuming power (212).

5. The liquid cooling method of anyone of claims 1 to 4, wherein the controlling of the at least one pump speed further comprises:
in response to determining that the flow rate has increased (302), incrementally increasing the at least on pump speed nₚᵤₘₚ (304);
determining whether the flow rate has remained the same after increasing the at least one pump speed nₚᵤₘₚ (306); and
in response to determining that the flow rate has not increased, continue to incrementally increase the at least on pump speed nₚᵤₘₚ (304).

6. The liquid cooling method of anyone of claims 1 to 5, wherein the controlling of the at least one pump speed further comprises that, in response to determining that the flow rate is not the same (306), decreasing the pump speed (308) and after an operating wait time period t, decreasing the pump speed again (310).

7. The liquid cooling method of anyone of claims 1 to 6, wherein the controlling of the at least one pump speed further comprises:
determining whether the flow rate based on the decreased pump speed is less than the previous flow rate (312); and
in response to determining that the flow rate based on the decreased pump speed is not less than the previous flow rate, continue decreasing the pump speed (310).

8. The liquid cooling method of anyone of claims 1 to 7 wherein, upon determining that the flow rate based on the decreased pump speed is less than the previous flow rate, increase the pump speed (314) and select and apply a pump head H pressure value to the at least one pump corresponding to the measured flow rate (316).

9. The liquid cooling method of anyone of claims 1 to 8 further comprising:
determining whether the applied H pressure value is less than a prescribed minimum H pressure value Hₘᵢₙ for the measured flow rate (318);
in response to determining that the applied H pressure value is less than Hₘᵢₙ, increasing the at least one pump speed nₚᵤₘₚ (322); and
in response to determining that the applied H pressure value is not less than Hₘᵢₙ, maintaining the previous at least one pump speed nₚᵤₘₚ (320).

10. The liquid cooling method of any one of claims 1 to 9, wherein the controlling of the at least one pump speed further comprises:
in response to determining that the measured flow rate has not increased (302), determining whether the flow rate remains the same (324) and if not, then incrementally decrease the at least on pump speed nₚᵤₘₚ (328);
in response to determining that the flow rate has not decreased (330), continue to incrementally decrease the at least on pump speed nₚᵤₘₚ (328);
in response to determining that the flow rate has decreased, incrementally increase the pump speed nₚᵤₘₚ (332).

11. The liquid cooling method of any one of claims 1 to 10, wherein the controlling of the at least one pump speed further comprises:
applying a pump head H pressure value to the at least one pump corresponding to the measured flow rate (334);
determining whether the applied H pressure value is less than a prescribed minimum H pressure value Hₘᵢₙ for the measured flow rate (336);
in response to determining that the applied H pressure value is less than Hₘᵢₙ, increasing the at least one pump speed nₚᵤₘₚ (338); and
in response to determining that the applied H pressure value is not less than Hₘᵢₙ, maintaining the previous at least one pump speed nₚᵤₘₚ (330).

12. A liquid cooling system (100) for rack-mounted processing assemblies (120A-120N), comprising:
a dry cooling unit (110) configured to supply a cooling liquid to the rack-mounted processing assemblies and receive a heated liquid from the rack-mounted processing assemblies, the dry cooling unit comprising a fan assembly (110A) and a heat exchanger unit (110B);
a first liquid distribution circuit (115) configured to convey the cooling liquid from the dry cooling unit to the rack-mounted processing assemblies, the first liquid distribution circuit incorporating at least one pump (112A, 112B) along the first liquid distribution circuit to provide a pressure flow in supplying the cooling liquid from the dry cooling unit to the rack-mounted processing assemblies;
a second liquid distribution circuit (125) configured to convey the heated liquid from the rack-mounted processing assemblies to the dry cooling unit;
each of the rack-mounted data processing assemblies (120A-120N) comprising:
at least one heat-generating electronic processing element,
at least one liquid cooling block arranged to be in respective thermal contact with the at least one heat-generating electronic processing element, the at least one liquid cooling block being fluidly-coupled to the first liquid distribution circuit to receive the cooling liquid and circulate therethrough, and
a smart control valve (122A-122N) respectively arranged to be fluidly-coupled to the at least one liquid cooling block of the corresponding rack-mounted data processing assembly, the smart control valve configured to be pressure independent and controls the flow rate of the cooling fluid of the corresponding rack-mounted data processing assembly based on detected temperatures and pressure flows;
the first liquid distribution circuit (115) including a first temperature sensor (126) configured to measure a temperature of the supplied cooling liquid T_{C} and a volume sensor (128) to measure a flow rate of the supplied cooling liquid V_{C};
the second liquid distribution circuit (125) including a second temperature sensor (130) configured to measure a temperature of the returned heated cooling liquid T_{H};
a third temperature sensor (132) configured to measure an ambient temperature of the dry cooling unit (110) T_{DC}; and
a control module (150), communicatively coupled to the fan assembly (110A) and the at least one pump (112A, 112B), the control module configured to:
receive the measured T_{C}, V_{C}, T_{H}, and T_{DC} values;
estimate a power consumption of the rack-mounted data processing assemblies by calculating a thermal load Q of the first liquid distribution circuit based on the measured T_{C}, T_{H}, and T_{DC} values (202);
control a speed of the fan assembly (208) based on the estimated power consumption and/or ambient conditions;
determine whether the flow rate has increased based on the measured V_{C} value (302); and
control a speed of the at least one pump (300) based on whether the flow rate has increased.

13. The liquid cooling system of claim 12, wherein the control of the fan assembly speed by the control module (150) further comprises:
evaluating the ambient temperature of the dry cooling unit T_{DC}, a current fan speed value n_{fan}, and estimated fan power consumption value Q_{fan-est} (204-206);
operating the fan assembly speed at the current fan speed value n_{fan}, and measuring actual power consumed by the fan assembly Q_{fan-real} (208);
determining whether the actual power consumed by the fan assembly Q_{fan-real} is greater than the estimated fan power consumption value Q_{fan-est} and a tolerance factor *K*_{factor} (210) and
in response to determining that Q_{fan-real} is greater than Q_{fan-est} and *K*_{factor}, issuing an alert message indicating that the fan assembly is overconsuming power (212).

14. The liquid cooling system of claim 12 or 13, wherein the control of the at least one pump speed by the control module further comprises:
in response to determining that the flow rate has increased (302), incrementally increasing the at least on pump speed nₚᵤₘₚ (304);
determining whether the flow rate has remained the same after increasing the at least one pump speed nₚᵤₘₚ (306);
in response to determining that the flow rate has not increased, continue to incrementally increase the at least on pump speed nₚᵤₘₚ (304);
in response to determining that the flow rate is not the same (306), decreasing the pump speed (308) and after an operating wait time period t, decreasing the pump speed again (310);
determining whether the flow rate based on the decreased pump speed is less than the previous flow rate (312);
in response to determining that the flow rate based on the decreased pump speed is not less than the previous flow rate, continue decreasing the pump speed (310);
upon determining that the flow rate based on the decreased pump speed is less than the previous flow rate, increase the pump speed (314) and select and apply a pump head H pressure value to the at least one pump corresponding to the measured flow rate (316);
determining whether the applied H pressure value is less than a prescribed minimum H pressure value Hₘᵢₙ for the measured flow rate (318);
in response to determining that the applied H pressure value is less than Hₘᵢₙ, increasing the at least one pump speed nₚᵤₘₚ (322); and
in response to determining that the applied H pressure value is not less than Hₘᵢₙ, maintaining the previous at least one pump speed nₚᵤₘₚ (320).

15. The liquid cooling system of anyone of claims 12 to 14, wherein the control of the at least one pump speed by the control module further comprises:
in response to determining that the measured flow rate has not increased (302), determining whether the flow rate remains the same (324) and if not, then incrementally decrease the at least on pump speed nₚᵤₘₚ (328);
in response to determining that the flow rate has not decreased (330), continue to incrementally decrease the at least on pump speed nₚᵤₘₚ (328);
in response to determining that the flow rate has decreased, incrementally increase the pump speed nₚᵤₘₚ (332);
applying a pump head H pressure value to the at least one pump corresponding to the measured flow rate (334);
determining whether the applied H pressure value is less than a prescribed minimum H pressure value Hₘᵢₙ for the measured flow rate (336);
in response to determining that the applied H pressure value is less than Hₘᵢₙ, increasing the at least one pump speed nₚᵤₘₚ (338); and
in response to determining that the applied H pressure value is not less than Hₘᵢₙ, maintaining the previous at least one pump speed nₚᵤₘₚ (330).

## Amended claims

### Amended claims in accordance with Rule 137(2) EPC.

1. A liquid cooling method (200, 300) for rack-mounted processing assemblies (120A-120N), comprising:
providing a dry cooling unit (110) to supply a cooling liquid to the rack-mounted processing assemblies and receive a heated liquid from the rack-mounted processing assemblies, the dry cooling unit comprising a fan assembly (110A) and a heat exchanger unit (110B);
providing a first liquid distribution circuit (115) to convey the cooling liquid from the dry cooling unit to the rack-mounted processing assemblies and a second liquid distribution circuit (125) to convey the heated liquid from the rack-mounted processing assemblies to the dry cooling unit, the first liquid distribution circuit (115) incorporating at least one pump (112A, 112B) along the first liquid distribution circuit (115) to provide a pressure flow in supplying the cooling liquid from the dry cooling unit to the rack-mounted processing assemblies;
each of the rack-mounted data processing assemblies (120A-120N) comprising at least one heat-generating electronic processing element and at least one liquid cooling block arranged to be in respective thermal contact with the at least one heat-generating electronic processing element and fluidly-coupled to the first liquid distribution circuit (115) and a smart control valve (122A-122N) respectively arranged to be fluidly-coupled to the at least one liquid cooling block of the corresponding rack-mounted data processing assembly, the smart control valve (122A-122N) configured to control the flow rate of the cooling fluid of the corresponding rack-mounted data processing assembly based on measured temperature values and measured flow rate values;
providing a first temperature sensor (126) along the first liquid distribution circuit (115) to measure a temperature of the supplied cooling liquid Tc and a volume sensor (128) to measure a flow rate of the supplied cooling liquid Vc;
providing a second temperature sensor (130) along the second liquid distribution circuit (125) to measure a temperature of the returned heated cooling liquid T_{H};
providing a third temperature sensor (132) to measure an ambient temperature of the dry cooling unit (110) T_{DC};
providing a characteristic H curve (400) representing head pressure values H versus liquid flow rates of the at least one pump (112A, 112B);
estimating a power consumption of the rack-mounted data processing assemblies by calculating a thermal load Q of the first liquid distribution circuit based on the measured T_{C}, T_{H} values (202);
controlling a speed of the fan assembly n_{fan}, by evaluating the estimated power consumption and ambient thermal conditions;
controlling a pump speed nₚᵤₘₚ of the at least one pump by evaluating whether the flow rate has changed from the measured Vc value (302, 304, 308, 310) and applying a corresponding head pressure value H (316, 318, 334, 336) to the changed flow rate to increase or decrease the pump speed nₚᵤₘₚ of the at least one pump.

2. The liquid cooling method of claim 1, wherein the controlling of the fan assembly speed further comprises evaluating the ambient temperature of the dry cooling unit T_{DC}, a current fan speed value n_{fan}, and estimated fan power consumption value Q_{fan-est} (204-206).

3. The liquid cooling method of claims 1 or 2, wherein the controlling of the fan assembly speed further comprises operating the fan assembly speed at the current fan speed value n_{fan}, and measuring actual power consumed by the fan assembly Q_{fan-real} (208).

4. The liquid cooling method of claims 2 or 3, wherein the controlling of the fan assembly speed further comprises:
determining whether the actual power consumed by the fan assembly Q_{fan-real} is greater than the estimated fan power consumption value Q_{fan-est} and a tolerance factor *K*_{factor} (210) and
in response to determining that Q_{fan-real} is greater than Q_{fan-est} and *K*_{factor}, issuing an alert message indicating that the fan assembly is overconsuming power (212).

5. The liquid cooling method of anyone of claims 1 to 4, wherein the controlling of the at least one pump speed further comprises:
in response to determining that the flow rate has increased (302), incrementally increasing the at least on pump speed nₚᵤₘₚ (304);
determining whether the flow rate has remained the same after increasing the at least one pump speed nₚᵤₘₚ (306); and
in response to determining that the flow rate has not increased, continue to incrementally increase the at least on pump speed nₚᵤₘₚ (304).

6. The liquid cooling method of anyone of claims 1 to 5, wherein the controlling of the at least one pump speed further comprises that, in response to determining that the flow rate is not the same (306), decreasing the pump speed (308) and after an operating wait time period t, decreasing the pump speed again (310).

7. The liquid cooling method of anyone of claims 1 to 6, wherein the controlling of the at least one pump speed further comprises:
determining whether the flow rate based on the decreased pump speed is less than the previous flow rate (312); and
in response to determining that the flow rate based on the decreased pump speed is not less than the previous flow rate, continue decreasing the pump speed (310).

8. The liquid cooling method of anyone of claims 1 to 7 wherein, upon determining that the flow rate based on the decreased pump speed is less than the previous flow rate, increase the pump speed (314) and select and apply a pump head H pressure value, based on a characteristic H curve (400) representing head pressure values versus liquid flow rates, to the at least one pump that corresponds to the measured flow rate (316).

9. The liquid cooling method of anyone of claims 1 to 8 further comprising:
determining whether the applied H pressure value is less than a prescribed minimum H pressure value Hₘᵢₙ for the measured flow rate (318);
in response to determining that the applied H pressure value is less than Hₘᵢₙ, increasing the at least one pump speed nₚᵤₘₚ (322); and
in response to determining that the applied H pressure value is not less than Hₘᵢₙ, maintaining the previous at least one pump speed nₚᵤₘₚ (320).

10. The liquid cooling method of any one of claims 1 to 9, wherein the controlling of the at least one pump speed further comprises:
in response to determining that the measured flow rate has not increased (302), determining whether the flow rate remains the same (324) and if not, then incrementally decrease the at least on pump speed nₚᵤₘₚ (328);
in response to determining that the flow rate has not decreased (330), continue to incrementally decrease the at least on pump speed nₚᵤₘₚ (328);
in response to determining that the flow rate has decreased, incrementally increase the pump speed nₚᵤₘₚ (332).

11. The liquid cooling method of any one of claims 1 to 10, wherein the controlling of the at least one pump speed further comprises:
applying a pump head H pressure value to the at least one pump corresponding to the measured flow rate (334);
determining whether the applied H pressure value is less than a prescribed minimum H pressure value Hₘᵢₙ for the measured flow rate (336);
in response to determining that the applied H pressure value is less than Hₘᵢₙ, increasing the at least one pump speed nₚᵤₘₚ (338); and
in response to determining that the applied H pressure value is not less than Hₘᵢₙ, maintaining the previous at least one pump speed nₚᵤₘₚ (330).

12. A liquid cooling system (100) for rack-mounted processing assemblies (120A-120N), comprising:
a dry cooling unit (110) configured to supply a cooling liquid to the rack-mounted processing assemblies and receive a heated liquid from the rack-mounted processing assemblies, the dry cooling unit comprising a fan assembly (110A) and a heat exchanger unit (110B);
a first liquid distribution circuit (115) configured to convey the cooling liquid from the dry cooling unit to the rack-mounted processing assemblies, the first liquid distribution circuit incorporating at least one pump (112A, 112B) along the first liquid distribution circuit to provide a pressure flow in supplying the cooling liquid from the dry cooling unit to the rack-mounted processing assemblies;
a second liquid distribution circuit (125) configured to convey the heated liquid from the rack-mounted processing assemblies to the dry cooling unit;
each of the rack-mounted data processing assemblies (120A-120N) comprising:
at least one heat-generating electronic processing element,
at least one liquid cooling block arranged to be in respective thermal contact with the at least one heat-generating electronic processing element, the at least one liquid cooling block being fluidly-coupled to the first liquid distribution circuit to receive the cooling liquid and circulate therethrough, and
a smart control valve (122A-122N) respectively arranged to be fluidly-coupled to the at least one liquid cooling block of the corresponding rack-mounted data processing assembly, the smart control valve configured to be pressure independent and controls the flow rate of the cooling fluid of the corresponding rack-mounted data processing assembly based on detected temperatures and pressure flows;
the first liquid distribution circuit (115) including a first temperature sensor (126) configured to measure a temperature of the supplied cooling liquid T_{C} and a volume sensor (128) to measure a flow rate of the supplied cooling liquid Vc;
the second liquid distribution circuit (125) including a second temperature sensor (130) configured to measure a temperature of the returned heated cooling liquid T_{H};
a third temperature sensor (132) configured to measure an ambient temperature of the dry cooling unit (110) T_{DC}; and
a control module (150), communicatively coupled to the fan assembly (110A) and the at least one pump (112A, 112B), the control module configured to:
receive the measured T_{C} ,V_{C}, T_{H}, and T_{DC} values;
estimate a power consumption of the rack-mounted data processing assemblies by calculating a thermal load Q of the first liquid distribution circuit based on the measured T_{C}, T_{H} values (202);
control a speed of the fan assembly n_{fan}, by evaluating the estimated power consumption and ambient thermal conditions; and
control a pump speed nₚᵤₘₚ of the at least one pump by evaluating whether the flow rate has changed from the measured Vc value (302, 304, 308, 310) and applying a corresponding head pressure value H (316, 318, 334, 336) to the changed flow rate to increase or decrease the pump speed nₚᵤₘₚ of the at least one pump,
wherein the corresponding head pressure value H is provided by a characteristic H curve (400) representing head pressure values H versus liquid flow rates of the at least one pump (112A, 112B).

13. The liquid cooling system of claim 12, wherein the control of the fan assembly speed by the control module (150) further comprises:
evaluating the ambient temperature of the dry cooling unit T_{DC}, a current fan speed value n_{fan}, and estimated fan power consumption value Q_{fan-est} (204-206);
operating the fan assembly speed at the current fan speed value n_{fan}, and measuring actual power consumed by the fan assembly Q_{fan-real} (208);
determining whether the actual power consumed by the fan assembly Q_{fan-real} is greater than the estimated fan power consumption value Q_{fan-est} and a tolerance factor *K*_{factor} (210) and
in response to determining that Q_{fan-real} is greater than Q_{fan-est} and *K*_{factor}, issuing an alert message indicating that the fan assembly is overconsuming power (212).

14. The liquid cooling system of claim 12 or 13, wherein the control of the at least one pump speed by the control module further comprises:
in response to determining that the flow rate has increased (302), incrementally increasing the at least on pump speed nₚᵤₘₚ (304);
determining whether the flow rate has remained the same after increasing the at least one pump speed nₚᵤₘₚ (306);
in response to determining that the flow rate has not increased, continue to incrementally increase the at least on pump speed nₚᵤₘₚ (304);
in response to determining that the flow rate is not the same (306), decreasing the pump speed (308) and after an operating wait time period t, decreasing the pump speed again (310);
determining whether the flow rate based on the decreased pump speed is less than the previous flow rate (312);
in response to determining that the flow rate based on the decreased pump speed is not less than the previous flow rate, continue decreasing the pump speed (310);
upon determining that the flow rate based on the decreased pump speed is less than the previous flow rate, increase the pump speed (314) and select and apply a pump head H pressure value to the at least one pump corresponding to the measured flow rate (316);
determining whether the applied H pressure value is less than a prescribed minimum H pressure value Hₘᵢₙ for the measured flow rate (318);
in response to determining that the applied H pressure value is less than Hₘᵢₙ, increasing the at least one pump speed nₚᵤₘₚ (322); and
in response to determining that the applied H pressure value is not less than Hₘᵢₙ, maintaining the previous at least one pump speed nₚᵤₘₚ (320).

15. The liquid cooling system of anyone of claims 12 to 14, wherein the control of the at least one pump speed by the control module further comprises:
in response to determining that the measured flow rate has not increased (302), determining whether the flow rate remains the same (324) and if not, then incrementally decrease the at least on pump speed nₚᵤₘₚ (328);
in response to determining that the flow rate has not decreased (330), continue to incrementally decrease the at least on pump speed nₚᵤₘₚ (328);
in response to determining that the flow rate has decreased, incrementally increase the pump speed nₚᵤₘₚ (332);
applying a pump head H pressure value to the at least one pump corresponding to the measured flow rate (334);
determining whether the applied H pressure value is less than a prescribed minimum H pressure value Hₘᵢₙ for the measured flow rate (336);
in response to determining that the applied H pressure value is less than Hₘᵢₙ, increasing the at least one pump speed nₚᵤₘₚ (338); and
in response to determining that the applied H pressure value is not less than Hₘᵢₙ, maintaining the previous at least one pump speed nₚᵤₘₚ (330).
